Europäisches Patentamt

European Patent Office

Office européen des brevets

(11) Veröffentlichungsnummer: **0 280 303**
**A2**

## EUROPÄISCHE PATENTANMELDUNG

(21) Anmeldenummer: **88102829.4**

(51) Int. Cl.⁴: **G01R 17/20**

(22) Anmeldetag: **25.02.88**

(30) Priorität: **26.02.87 DD 300214**

(43) Veröffentlichungstag der Anmeldung:
**31.08.88 Patentblatt 88/35**

(84) Benannte Vertragsstaaten:
**CH DE FR GB IT LI NL**

(71) Anmelder: **VEB KOMBINAT WOLLE UND SEIDE**
**Leipziger Strasse 32-34**
**DDR-9612 Meerane(DD)**

(72) Erfinder: **Loy, Hans-Jörg**
**Eilenburger Strasse 41**
**DDR-7050 Leipzig(DD)**
Erfinder: **Rahm, Norbert**
**Wilhelm-Pieck-Allee 17/0403**
**DDR-7060 Leipzig(DD)**

(74) Vertreter: **Ebbinghaus, Dieter et al**
**Patentanwälte v. Füner, Ebbinghaus, Finck**
**Mariahilfplatz 2 & 3**
**D-8000 München 90(DE)**

(54) **Verfahren und Anordnung zur automatischen Messung von Gleichströmen.**

(57) Die Erfindung betrifft ein Verfahren und eine Anordnung zur Durchführung des Verfahrens zur automatischen Messung von Gleichströmen oder physikalischer Größen, die sich darauf zurückführen lassen, insbesondere für Meßaufgaben über eine große Anzahl von Dekaden mit gleichbleibend hoher Genauigkeit und/oder ohne den Meßstromkreis zu belasten.

Ein zu messender Gleichstrom (2) wird in einem Kompensationspunkt (1), der durch einen Komparator (4) überwacht wird, durch einen Referenzstrom (3) entgegengesetzter Richtung nach dem Prinzip der Sukzessivapproximation kompensiert. Der Referenzstrom (3) wird durch eine Kombination von Kompensationselementen (5), bestehend aus digital umschaltbaren Referenzwiderständen (9) und einer digital steuerbaren Referenzspannungsquelle (10), erzeugt. Die Auswertung des Komparatorausgangs, die Steuerung der Kompensationselemente (5), die Ermittlung des zu messenden Stroms (2) und die Ausgabe des Meßwertes erfolgt in einer Auswerte-und Steuereinrichtung (6), die durch einen Mikrorechner realisiert ist.

Fig. 1

## Verfahren und Anordnung zur automatischen Messung von Gleichströmen

Die Erfindung betrifft ein Verfahren und eine Anordnung zur automatischen Messung von Gleichströmen nach der Kompensationsmethode unter Verwendung des Prinzips der Sukzessivapproximation, insbesondere für Meßaufgaben über eine große Anzahl von Dekaden mit gleichbleibend hoher Genauigkeit und/oder ohne den Meßstromkreis zu belasten.

Die Messung von Gleichströmen erfordert bei der Anwendung bekannter Verfahren einen Referenzwiderstand zur Umsetzung in eine äquivalente Spannung, der die Stromverhältnisse im Meßstromkreis mehr oder weniger verfälscht.
Zur Messung kleiner Gleichströme über mehrere Dekaden werden überwiegend logarithmische, hochverstärkende stabilisierte oder Zerhackerverstärker eingesetzt. Benutzt man einen Strom-Spannungs-Verstärker, treten an dessen Eingang besonders bei kleinen Meßströmen, bedingt durch die endliche Verstärkung, erhebliche Potentialverschiebungen auf.

Bei diesen bekannten Lösungen lassen sich die Forderungen nach großem Meßbereich, geringster Verfälschung des zu messenden Stroms und hoher Genauigkeit nicht gleichzeitig realisieren. Außerdem ist die Belastung des Meßstromkreises nicht vollständig zu eliminieren und die Forderung nach großem Signal-Rausch-Abstand bei diesen analogen Meßverfahren steht den minimal meßbaren Größen ebenso enge Grenzen wie das Offset-Verhalten.

Logarithmische und hochverstärkende stabilisierte Verstärker wirken selbst bei umfangreichen Stabilisierungsmaßnahmen nur über eine beschränkte Anzahl von Dekaden mit gleichbleibend hoher Genauigkeit.
Bei Zerhackerverstärkern lassen sich die Einflüsse des Abtastgliedes nur über einen kleinen Meßbereich hinrei chend kompensieren.
Einrichtungen zur Umschaltung des Meßbereiches in Abhängigkeit von der zu messenden Größe besitzen den Nachteil, daß der Aufwand im Verhältnis zur erzielbaren Meßbereichserweiterung groß ist.

Der Erfindung liegt die Aufgabe zugrunde, ein Verfahren und eine Anordnung zur automatischen Messung von Gleichströmen zu schaffen, mit der es möglich ist, Gleichströme über eine große Anzahl von Dekaden mit gleichbleibend hoher Genauigkeit automatisch zu messen, ohne dabei den Meßstromkreis zu belasten.

Erfindungsgemäß wird die Aufgabe dadurch gelöst, daß der zu messende Strom in einem durch einen Komparator überwachten Kompensationspunkt durch einen Referenzstrom entgegengesetzter Richtung kompensiert wird. Der Referenzstrom wird durch automatische Umschaltung von einem oder mehreren Kompensationselementen erzeugt. An den zu messenden Strom wird der Referenzstrom mittels des Komparators und einer Auswerte-und Steuereinrichtung sukzessiv approximiert, wobei nach erfolgter Approximation das digitale Abbild des zu messenden Stromes vorliegt.

Die Anordnung zur Durchführung des Verfahrens beinhaltet, daß der Komparator eingangsseitig in einem Kompensationspunkt mit dem Meßstrom und mit dem in einem oder mehreren Kompensationselementen erzeugten Referenzstrom verbunden ist. Der Komparatorausgang ist mit der Auswerte-und Steuereinrichtung verbunden, der ein Interface zu Sekundärgeräten nachgeschaltet ist und die rückkoppelnd mit den Kompensationselementen verbunden ist.

Mittels des Komparators, dessen Ansprechschwelle an die geforderte Genauigkeit angepaßt ist, wird des Potential am Kompensationspunkt gegenüber dem Bezugspotential ausgewertet. Der statische Ausgangszustand des Komparators gibt Aufschluß über die Polarität des Potentials am Kompensationspunkt und damit über die notwendige Änderungsrichtung des Referenzstromes, eine Änderung des Ausgangszustandes stellt das Erreichen bzw. Überschreiten des Kompensationszustandes fest.

Eine bekannte Auswerte-und Steuereinrichtung wertet den Ausgangszustand des Komparators aus und steuert die Kompensationselemente, die eine Referenzstromquelle darstellen, derart, daß der Referenzstrom sukzessiv an den zu messenden Strom approximiert wird. Gleiche Potentiale zeigen die vollständige Kompensation des zu messenden Stromes an.

In diesem Zustand haben Nebenschlüsse zwischen Kompensations-und Bezugspunkt keinen Einfluß mehr auf die Genauigkeit des Meßwertes. Darüberhinaus ist sowohl die Differenz-als auch die Gleichtakteingangsspannung im Gegensatz zum Spannungsvergleichsverfahren immer annähernd Null, so daß der Komparator nur für diesen Eingangszustand dimensioniert und kompensiert werden muß. Im unkompensierten Zustand bestimmt die Empfindlichkeit des Komparators in Zusammenhang mit der geforderten Genauigkeit die zulässige Größe eines Nebenschlusses. Hysteresefehler des Komparators bleiben dadurch unwirksam, daß man sich dem Kompensationszustand immer aus einer Richtung nähert. Aus der Stellung der Kompensationselemente ist nach beendeter Approximation der Meßwert durch einfache mathematische Operationen ableitbar.

Ausführungsbeispiel

Die Erfindung soll nachstehend anhand eines Ausführungsbeispieles näher erläutert werden.

In der Zeichnung zeigen:

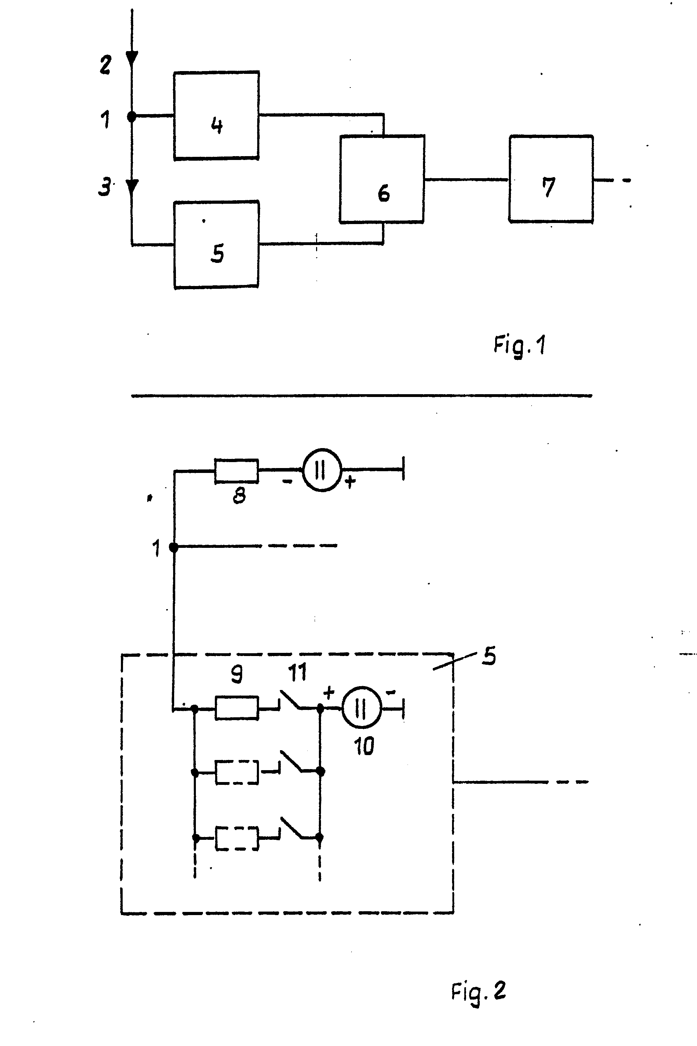

Fig. 1 das Blockschaltbild,

Fig. 2 die Prinzipskizze für die Meßaufgabe.

Die erfindungsgemäße Lösung wurde in einem Gerät zur Bestimmung der Materialfeuchte nach dem Leitfähigkeitsprinzip verwendet. Dabei waren materialfeuchtigkeitsabhängige Widerstände 8 von $10^4$ bis $10^{12}$ Ohm mit einer Genauigkeit von $\pm$ 1 % zu bestimmen.

Um den Referenzstrom 3, der erfindungsgemäß die gleiche Größe wie der zu messende Strom annehmen muß, erzeugen zu können, ist unter den Forderungen des großen Meßbereichs, der hohen Genauigkeit und der digitalen Einstellbarkeit keine in sich geschlossene Schaltung einer Referenzstromquelle einsetzbar. Vielmehr wird eine Kombination von Kompensationselementen 5, bestehend aus digital einstellbarer Referenzspannungsquelle 10 und umschaltbarer Referenzwiderstände 9 eingesetzt. Die Zuleitungen zum Kompensationspunkt 1 sind gegen elektromagnetische Störbeeinflussung geschützt ausgeführt und die Referenzwiderstände 9 werden mit Relaiskontakten 11 geschaltet.

Zur Offset-und Offsetdriftkompensation wird vor jeder Messung und nach jeder Umschaltung der Referenzwiderstände 9 eine Auto-Zero-Phase eingefügt.

Vor Beginn der Approximation wird durch Erzeugung des höchst zulässigen bzw. kleinstmöglichen Referenzstromes 3 die Einhaltung des Meßbereiches überprüft. Die Approximation beginnt mit der Einstellung des Strommeßbereichs (dekadisch oder dual gestuft) durch Umschaltung der Referenzwiderstände 9 vom niedrigsten zum höchsten bei maximaler Referenzspannung. Bei Änderung des Komparatorausgangszustandes wird auf den zuvor eingeschalteten Referenzwiderstand 9 geschaltet. Die weitere Kompensation erfolgt durch Einstellen der Referenzspannung nach dem Prinzip der Sukzessivapproximation. Aus der Stellung der Kompensationselemente 5 nach erfolgter Kompensation ist der Meßwert durch einfache mathematische Operationen zu gewinnen.

Diese Aufgabe wird ebenso wie die Auswertung des Komparatorausgangs, die Steuerung der Kompensationselemente 5, die anwendungsspezifische Meßwertkorrektur und die Ausgabe des Meßwertes über ein Interface 7 durch einen Mikrorechner realisiert.

**Ansprüche**

1. Verfahren zur automatischen Messung von Gleichströmen ohne Belastung des meßstromkreises über eine große Anzahl von Dekaden mit gleichbleibend hoher Genauigkeit unter Verwendung bekannter Komparatoren, Kompensationselemente, Auswerte-und Steuereinrichtungen und Interfaces, dadurch gekennzeichnet, daß der zu messende Strom in einem durch einen Komparator überwachten Kompensationspunkt durch einen Referenzstrom entgegengesetzter Richtung, der durch automatische Umschaltung von einem oder mehreren Kompensationselementen erzeugt, an den zu messenden Strom unter Verwendung mittels eines Komparators und einer Auswerte-und Steuereinrichtung sukzessiv approximiert wird und nach erfolgter Approximation als Abbild des zu messenden Stromes anhand der Zustände der Kompensationselemente digital vorliegt, kompensiert wird.

2. Anordnung zur Durchführung des Verfahrens nach Anspruch 1, dadurch gekennzeichnet, daß der Komparator (4) eingangsseitig in einem Kompensationspunkt (1) mit dem Meßstrom (2), dem in einem oder mehreren Kompensationselementen (5) erzeugten Referenzstrom (3) und ausgangsseitig mit einer Auswerte-und Steuereinrichtung (6), nachgeschaltet mit einem Interface (7) zu Sekundärgeräten und den rückkoppelnd geschalteten Kompensationselementen (5), verbunden ist.

EPAB-36187.5

Fig. 1

Fig. 2